# EUROPEAN PATENT SPECIFICATION

(11) **EP 0 312 606 B1**
(45) Date of publication and mention of the grant of the patent: **31.08.1994**
(21) Application number: 88903400.5
(22) Date of filing: 25.04.1988
(51) Int. Cl.: H03K 17/56, H03K 17/60, H03K 17/687, H03K 17/16

(54) **PRE-DRIVE CIRCUIT**
VORSTEUERSCHALTUNG
CIRCUIT DE PRE-COMMANDE

(30) Priority: 30.04.1987 JP 107253/87
(43) Date of publication of application: 26.04.1989
(73) Proprietor: FANUC LTD., Minamitsuru-gun, Yamanashi 401-05 (JP)
(72) Inventor: NAKAMURA, Shigeo Mansion Harimomi 7-305, Minamitsuru-gun Yamanashi 401-05 (JP)
(74) Representative: Billington, Lawrence Emlyn
(86) International application number: PCT/JP88/00403
(87) International publication number: WO 88/08643

(56) References cited:
- JP-U- 5 857 129
- JP-U-54 129 254
- PATENT ABSTRACTS OF JAPAN, vol. 4, no. 189 (E-39)[671], 25th December 1980;& JP-A-55 128 923 (KIYOUSAN SEISAKUSHO K.K.) 06-10-1980
- MODERN ELECTRONIC CIRCUITS MANUAL, J.Markus, McGraw-Hill 1980, p191

## Description

This invention relates to a pre-drive circuit for use in a switching regulator, a DC/DC converter, etc.

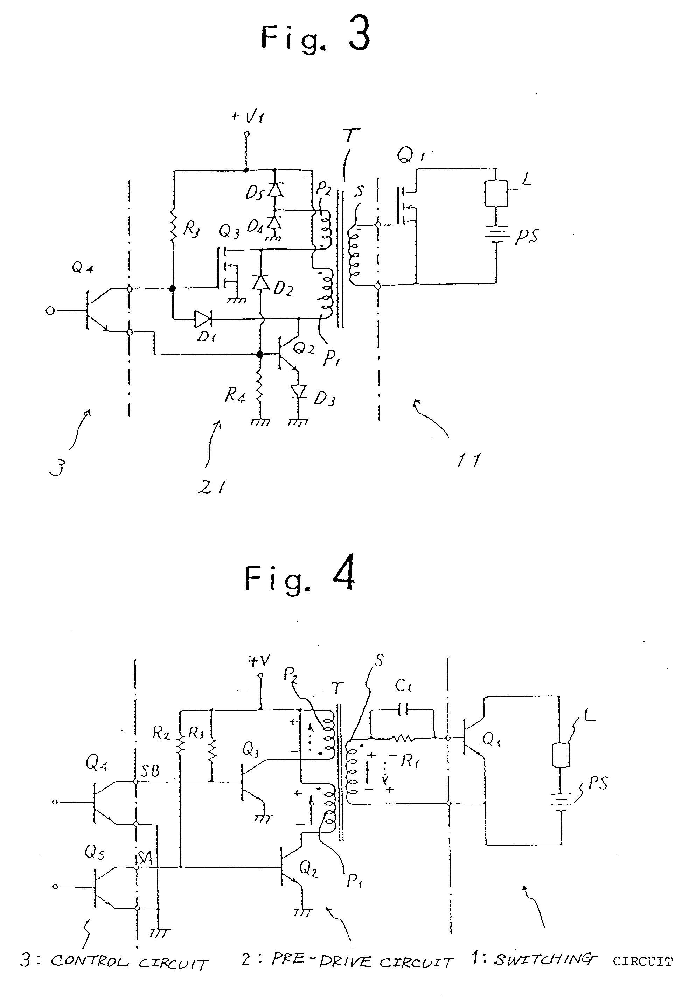

A pre-drive circuit which performs the on-off control of a switching transistor element through a pulse transformer is one which on/off controls the power transistor of a switching circuit by the use of two drive transistors as illustrated in Fig. 4.

With reference to Fig. 4, a switching circuit 1 on/off controls a power source PS for a load L by means of a power transistor Q₁ and is connected to a control circuit 3 through a pre-drive circuit 2. Connected across the base and emitter of the power transistor Q₁ through a parallel circuit consisting of a resistor R₁ and a capacitor C is a secondary coil S of the pulse transformer T. On the primary side of the pulse transformer, a transistor Q₂ is connected to a first primary coil P₁, and a transistor Q₃ is connected to a second primary coil P₂.

To turn on the power transistor Q₁, a signal output transistor Q₅ of the control circuit 3 is turned off to turn on the transistor Q₂. When the transistor Q₂ is turned on, voltages of polarities indicated by solid lines in the figure are generated in the pulse transformer T, and current flows to the base of the power transistor Q₁ to bring this power transistor Q₁ to the on state.

To turn off the power transistor Q₁, the signal output transistor Q₅ is turned on to turn off the transistor Q₂, while at the same time, a signal output transistor Q₄ is turned off to turn on the transistor Q₃. The base charge of the power transistor Q₁ is extracted by voltages of polarities indicated by the broken lines in the figure, thereby turning off this power transistor Q₁.

With such a prior-art pre-drive circuit, the transistor Q₂ is turned off and the transistor Q₃ is simultaneously turned on in order to turn off the power transistor Q₁. In this regard, the conventional transistors involve a delay in terms of the response of collector current to base current, and when control signals SA and SB to be applied to the pre-drive circuit 2 are provided with exactly opposite phases, the transistors Q₂ and Q₃ are turned on simultaneously. At this moment, excess currents flow through both the transistors Q₂ and Q₃, resulting in the useless generation of heat. This makes it necessary to delay slightly the time at which the transistor Q₃ turns on.

Moreover, the prior art involves problems in terms of the current efficiency and circuit arrangement thereof. That is, the control circuit requires the two signal output transistors Q₄ and Q₅ in order to supply the respective transistors Q₂ and Q₃ with the control signals SA and SB.

Modern Electronic Circuits Reference Manual, 1982, J. Marcus, p. 191, "28-V High Efficiency", discloses a pre-drive circuit according to the preamble of accompanying claim 1.

The present invention has been devised in view of the foregoing problems, and provides a pre-drive circuit in which feedback circuits are cross-connected to transistors serving as switching elements, wherein after one of the transistors is turned off, the other transistor is turned on, thereby simplifying the arrangement of a control circuit and preventing the useless generation of heat.

According to the present invention, there is provided a pre-drive circuit which performs on/off control of a switching transistor element through a pulse transformer having two primary windings, comprising:-
first and second switching elements arranged to control currents flowing through the respective primary windings; and
feedback circuits which cross-connect the respective signal output terminals and control terminals of the first and second switching elements; whereby each said feedback circuit is arranged so as to divert current away from the control terminal to which it is connected, so as to delay switching of the corresponding switching element ;
characterised in that:-
an active control element is provided, having first and second output terminals which are connected to the control terminals of the first and second switching elements respectively, for supply of respective control signals thereto .

With the pre-drive circuit of the present invention, a corresponding one of the feedback circuits is connected from the signal output terminal of one switching element to the control element of the other switching element, whereby after one switching element has completely turned off, the other switching element turns on. Accordingly, excess currents can be prevented from developing in the pre-drive circuit and the arrangement of the control circuit can be simplified.

In the drawings:

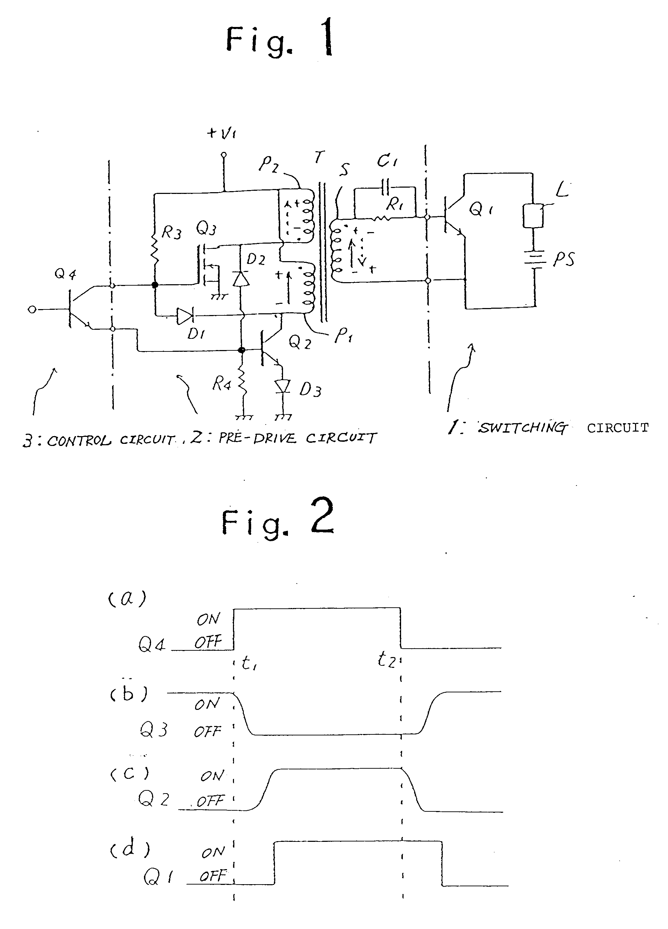

Fig. 1 is a circuit diagram of a pre-drive circuit and its peripheral circuits showing an embodiment of the present invention, Fig. 2 is a chart showing the operation timing of the circuit of the embodiment, Fig. 3 is a circuit diagram showing another embodiment of the present invention, and Fig. 4 is a circuit diagram showing an example of a prior-art circuit arrangement.

An embodiment of the present invention will now be described in detail with reference to the drawings.

Fig. 1 shows a pre-drive circuit illustrative of one embodiment of the present invention. Although shown in a simplified form in the figure, a switching circuit 1 to be driven by a pre-drive circuit 2 includes a power transistor Q₁, etc. This power transistor Q₁ is turned on and off by current which is supplied from a pulse transformer T.

The emitter of the power transistor Q₁ is connected to the negative side of the power source PS of the switching circuit 1 and is also connected to one end of the secondary coil S of the pulse transformer T. The other end of the secondary coil S is connected to the base of the transistor Q₁ through a parallel circuit consisting of a resistor R₁ and a capacitor C₁.

On the primary side of the pulse transformer T, two primary coils P₁ and P₂ are arranged in opposite phases to each other. The collector of a conventional bipolar transistor Q₂ is connected to the first primary coil P₁, while the drain of a MOS-type FET Q₃ as the second switching element is connected to the second primary coil P₂. In addition, a diode D₁ which functions as a feedback circuit is connected in the reverse direction from the collector terminal of the transistor Q₂ to the gate terminal of the FET Q₃, while a diode D₂ which functions as a feedback circuit is connected in the reverse direction from the drain terminal of the FET Q₃ to the base terminal of the transistor Q₂. Further, a diode D₃ is connected in the forward direction between the emitter of the transistor Q₂ and ground, whereby the potential difference of the transistor Q2 relative to ground is raised by an amount corresponding to the forward potential difference across the diode D₃. Meanwhile, a control circuit 3 which delivers control signals to the pre-drive circuit 2 has a signal output transistor Q₄, the emitter and collector of which are respectively connected to the base of the transistor Q₂ and the gate of the FET Q₃. Thus, the control circuit applies a predetermined voltage from a voltage source V₁ through a resistor R₃ to the node between the collector of the transistor Q₄ and the gate of the FET Q₃, thereby to determine the base current of the transistor Q₂ when the transistor Q₄ is on, and supplies a sufficient voltage to the gate of the FET Q₃ when the transistor Q₄ is off, thereby to turn on this FET.

Fig. 2 exemplifies on and off operation timing in the circuit of the embodiment of the above arrangement. Fig. 2(a) shows the state of the signal output transistor Q₄ of the control circuit 3, (b) the state of the FET Q₃, (c) the state of the transistor Q₂, and (d) the state of the power transistor Q₁.

When the transistor Q₄ is turned on with the intention of turning on the power transistor Q₁, currents attempt to flow from the resistor R₃ and the gate of the FET Q₃ through the transistor Q₄ to the base of the transistor Q₂. However, since current flows to the drain of the FET Q₃ through the diode D₂ -while the FET Q₃ is on, the transistor does not turn on. When the FET Q₃ turns off owing to the extinction of the gate charges thereof, the current through the diode D₂ fails to flow, and the current flows to the base of the transistor Q₂ instead, so that this transistor Q₂ turns on. Thus, voltages of polarities indicated by the solid lines in Fig. 1 are generated in the pulse transformer T, and the power transistor Q₁ is turned on.

On the other hand, when the transistor Q₄ is turned off with the intention of turning off the power transistor Q₁, the transistor Q₂ has its base current cut off and turns off after elapse of a period of time required for the extinction of the charges of the base thereof. During the time that the transistor Q₂ is on, current from the resistor R₃ flows to the collector of the transistor Q₂ through the diode D₁, and the gate voltage of the FET Q₃ remains low in spite of the off state of the transistor Q₄; hence, the FET Q₃ does not turn on. When the transistor Q₂ turns off to raise the collector voltage thereof, the FET Q₃ has its gate voltage raise and turns on. Thus, voltages in polarities indicated by the broken lines in the figure are generated in the pulse transformer T, and the power transistor Q₁ is turned off.

Fig. 3 is a circuit diagram showing another embodiment of the present invention. In this embodiment, the power transistor Q₁′ of a switching circuit 11 to be controlled by the pre-drive circuit 21 is a MOSFET, and the circuit arrangement of a FET Q₃ connected to the secondary primary coil differs from that in the case of Fig. 1.

Operation at the time the power transistor Q₁′ attempts to turn on is the same as in the case of Fig. 1. Further, as regards operation at the time the power transistor Q₁′ attempts to turn off, operation until the FET Q₃ turns on is the same as in the case of Fig. 2. When the FET Q₃ turns on, both ends of the secondary coil are equivalently short-circuited, so that the voltage at the gate of the power transistor Q₁′ connected to the secondary coil becomes about zero to turn off the power transistor Q₁′.

Thus, in the pre-drive circuit illustrated in each of the embodiments, the gate voltage required to turn on the FET Q₃ is usually 2 V or above; hence, the emitter and collector of the single signal output transistor Q₄ are respectively connected to the transistor Q₂ and the FET Q₃, whereby the transistor Q₂ and the FET Q₃ can be prevented from being turned on simultaneously by the transistor Q₄. This prevents the useless generation of heat in the pulse transformer T and the transistor Q₂ as well as the FET Q₃.

Though two embodiments of the present invention have been described, the invention can be modified in a variety of ways.

When used in a switching regulator, a DC/DC converter or the like, the pre-drive circuit of the present invention can improve the current efficiency and circuit arrangement thereof.

## Claims

1. A pre-drive circuit (2) which performs on/off control of a switching transistor element (Q₁, Q₁′) through a pulse transformer (T) having two primary windings (P₁, P₂), comprising:-
first and second switching elements (Q₂, Q₃) arranged to control currents flowing through the respective primary windings (P₁, P₂); and
feedback circuits (D₁, D₂) which cross-connect the respective signal output terminals and control terminals of the first and second switching elements (Q₂, Q₃), whereby each said feedback circuit (D₁, D₂) is arranged so as to divert current away from the control terminal to which it is connected, so as to delay switching of the corresponding switching element (Q₂, Q₃) ;
characterised in that:-
an active control element (Q₄) is provided, having first and second output terminals which are connected to the control terminals of the first and second switching elements (Q₂, Q₃) respectively, for supply of respective control signals thereto .

2. A pre-drive circuit according to claim 1, wherein said each feedback circuit (D₁, D₂) comprises a diode arranged with its forward direction towards the respective signal output terminal of the switching elements.

3. A pre-drive circuit according to claim 1 or 2, wherein a bipolar transistor (Q₂) is employed as one of said switching elements, while an insulated-gate field-effect transistor (Q₃) is employed as the other.

4. A pre-drive circuit according to claim 1, 2, or 3, wherein said control element (Q₄) is a bipolar transistor whose collector and emitter form said first and second output terminals.

## Patentansprüche

1. Treiberschaltung (2), die das Steuern des Ein- und Ausschaltens eines Schalttransistorelements (Q₁, Q₁′) über einen Impulstransformator (T) mit zwei Primärwicklungen (P₁, P₂) ausführt, umfassend
erste und zweite Schaltelemente (Q₂, Q₃), die zum Steuern des Stroms, der durch die entsprechenden Primärwicklungen (P₁, P₂) fließt, eingerichtet sind; und
Rückkoppelschaltungen (D₁, D₂), die zwischen die entsprechenden Signalausgabeanschlüsse und Steueranschlüsse des ersten und des zweiten Schaltelements (Q₂, Q₃) geschaltet sind, wobei jede Rückkoppelschaltung (D₁, D₂) so eingerichtet ist, daß sie Strom von dem mit ihr verbundenen Steueranschluß ableitet, wodurch das Schalten des entsprechenden Schaltelements (Q₂, Q₃) verzögert wird,
dadurch gekennzeichnet, daß ein aktives Steuerelement (Q₄) mit ersten und zweiten Ausgangsanschlüssen bereitgestellt wird, die mit den entsprechenden ersten und zweiten Schaltelementen (Q₂, Q₃) verbunden sind, geeignet zum Anlegen der jeweiligen Steuersignale an die Schaltelemente .

2. Treiberschaltung nach Anspruch 1, wobei jede Rückkoppelschaltung (D₁, D₂) eine Diode enthält, deren Durchlaßrichtung auf den entsprechenden Signalausgabeanschluß des Schaltelements zeigt.

3. Treiberschaltung nach Anspruch 1 oder 2, wobei ein Bipolartransistor (Q₂) als ein Schaltelement verwendet wird, wogegen ein Feldeffekt-Transistor mit isoliertem Gate (Q₃) als anderes Schaltelement verwendet wird.

4. Treiberschaltung nach Anspruch 1, 2 oder 3, wobei das Steuerelement (Q₄) ein Bipolartransistor ist, dessen Kollektor und Emitter den ersten und zweiten Ausgangsanschluß bilden.

## Revendications

1. Circuit de précommande (2) qui réalise la commande de conduction/blocage d'un élément transistor de commutation (Q₁, Q₁′) par l'intermédiaire d'un transformateur d'impulsions (T) qui possède deux enroulements primaires (P₁, P₂), comprenant :
des premier et deuxième éléments de commutation (Q₂, Q₃) destinés à commander les courants passant dans les enroulements primaires respectifs (P₁, P₂) ; et
des circuits de réaction (D₁, D₂) qui connectent en croix les bornes de sortie de signal et les bornes de commande respectives des premier et deuxième éléments de commutation (Q₂, Q₃), si bien que chaque dit circuit de réaction (D₁, D₂) est amené à dériver du courant de la borne de commande à laquelle il est connecté, afin de retarder la commutation de l'élément de commutation correspondant (Q₂, Q₃) ;
caractérisé en ce que :
il est prévu un élément de commande actif (Q₄), possédant des première et deuxième bornes de sortie qui sont respectivement connectées aux bornes de commande des premier et deuxième éléments de commutation (Q₂, Q₃), afin de leur fournir des signaux de commande respectifs.

2. Circuit de précommande selon la revendication 1, où chaque dit circuit de réaction (D₁, D₂) comprend une diode disposée de façon que son sens passant soit dirigé vers la borne de sortie de signal respective des éléments de commutation.

3. Circuit de précommande selon la revendication 1 ou 2, où un transistor bipolaire (Q₂) est employé au titre de l'un desdits éléments de commutation, tandis qu'un transistor à effet de champ à grille isolée (Q₃) est employé au titre de l'autre élément de commutation.

4. Circuit de précommande selon la revendication 1, 2 ou 3, où ledit élément de commande (Q₄) est un transistor bipolaire dont le collecteur et l'émetteur forment lesdites première et deuxième bornes de sortie.
